(19) Europäisches Patentamt
European Patent Office
Office européen des brevets

(11) EP 0 528 713 B1

(12) FASCICULE DE BREVET EUROPEEN

(45) Date de publication et mention
de la délivrance du brevet:
10.05.2000 Bulletin 2000/19

(51) Int. Cl.⁷: **H01L 21/321**, H01L 21/033

(21) Numéro de dépôt: 92402207.2

(22) Date de dépôt: 31.07.1992

(54) **Procédé de contrôle du profil de gravure d'une couche d'un circuit intégré**

Verfahren zur Kontrolle der Ätzkontur einer Schicht einer integrierten Schaltung

Process for controlling the etched profile of a layer of an integrated circuit

(84) Etats contractants désignés:
DE GB IT

(30) Priorité: 05.08.1991 FR 9109951

(43) Date de publication de la demande:
24.02.1993 Bulletin 1993/08

(73) Titulaire: **MHS**
**44087 Nantes Cédex 03 (FR)**

(72) Inventeur:
**Rabinzohn, Patrick Daniel**
**F-44860 Pont-Saint-Martin (FR)**

(74) Mandataire:
**Fréchède, Michel et al**
**Cabinet Plasseraud**
**84, rue d'Amsterdam**
**F-75009 Paris (FR)**

(56) Documents cités:
EP-A- 0 147 332      GB-A- 2 137 143
US-A- 4 436 584      US-A- 4 678 540

- **PROCEEDINGS OF THE 3RD INT. IEEE MULTILEVEL INTERCONNECTION CONF., 9-10 JUIN 1986, SANTA CLARA, CA, USA pages 198 - 204 ABRAHAM 'Sidewall tapering of plasma etched metal interconnects'**
- **JAPANESE JOURNAL OF APPLIED PHYSICS. vol. 28, no. 6, Juin 1989, TOKYO JP pages L1070 - L1072 OHNO ET AL 'Reactive ion etching of copper films in SiCl4 and N2 mixtures'**
- **PROCEEDINGS OF THE SPIE, VOL. 923 : ELECTRON-BEAM, X-RAY AND ION-BEAM TECHNOLOGY : SUBMICROMETER LITHOGRAPHIES VII, 2-4 MARS 1988 SANTA CLARA, CA, USA pages 55 - 62 ZWICKER ET AL 'Fabrication of 0.5 um poly-Si and aluminum interconnections by means of X-ray lithography and plasma etching'**
- **JOURNAL OF THE ELECTROCHEMICAL SOCIETY vol. 137, no. 6, Juin 1990, MANCHESTER, NEW HAMPSHIRE US pages 1907 - 1911 KUO 'Factors affecting the Molybdenum line slope by reactive ion etching'**

**Description**

La présente invention est relative à un procédé de contrôle du profil de gravure d'une couche d'un circuit intégré.

Outre le contrôle dimensionnel de la gravure des couches de circuit intégrés, le contrôle des profils de gravure, c'est-à-dire de la loi spatiale de gravure dans une direction orthogonale à la surface du substrat du circuit intégré, intervient de manière de plus en plus sensible dans l'évolution des techniques de gravure en micro-électronique.

Suite à l'avènement de la gravure sèche, ou gravure plasma, le contrôle du profil des trous d'interconnexion formés dans le diélectrique d'isolement entre niveaux, semi-conducteur ou conducteur, fut le premier problème posé. Dans un tel cas, la solution consiste à utiliser une gravure anisotrope, c'est-à-dire ne comportant qu'une composante orthogonale à la surface du substrat ; en particulier de la couche diélectrique telle que SiO2. Le contrôle de la pente s'obtient par consommation ou érosion du masque de réserve (photorésist).

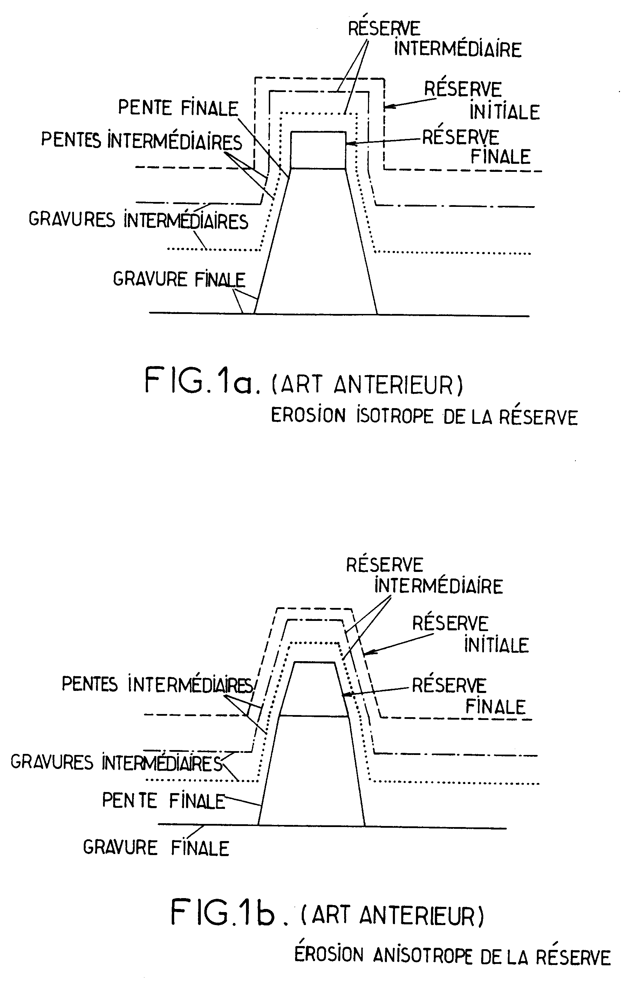

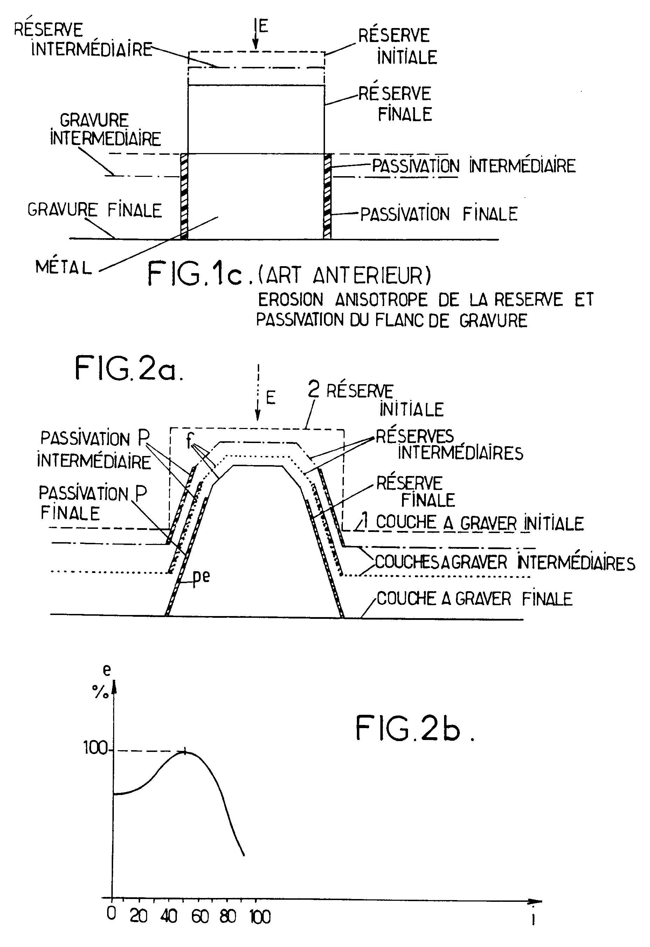

Ainsi que représenté sur la figure 1a) relative à un premier mode de réalisation de la technique antérieure, cette érosion peut être isotrope, une telle érosion présentant toutefois l'inconvénient d'une trop grande sensibilité aux effets de charge, c'est-à-dire de surface à graver, de distance entre motifs et de taille des motifs. Cette érosion peut également, ainsi que représenté en figure 1b, être anisotrope. Une telle érosion nécessite toutefois de profiler le masque de réserve, c'est-à-dire d'adapter son profil préalablement au processus de gravure proprement dit. Les techniques d'adaptation employées à cet effet comportent le plus souvent un traitement thermique, tel que le fluage, et s'avèrent inadaptées à la réalisation de motifs microniques et a fortiori submicroniques. Un tel procédé par gravure anisotrope a été décrit par le document "Proceedings of the 3d Int. IEEE CLSI Multilevel Conf. P 198 à 204 - June 9-10 1986 et par le brevet US 4 678 540. Ce procédé permet l'obtention d'une pente sur le métal suite à l'érosion de la résine facettée au préalable.

En ce qui concerne le contrôle du profil de gravure des matériaux d'interconnexion, ce dernier, jusqu'à présent, s'est essentiellement limité à celui de l'anisotropie de gravure, c'est-à-dire au contrôle du caractère vertical, soit orthogonal à la surface, de ce profil. Ainsi que représenté en figure 1c, la gravure anisotrope d'un métal, tel que l'aluminium, nécessite la passivation du flanc de gravure, c'est-à-dire la formation d'une couche mince inhibant le risque d'attaque latérale par l'agent de gravure, lequel dans ce cas particulier est constitué par le chlore atomique provenant de la molécule $Cl_2$. Une telle passivation est le plus souvent obtenue par formation et dépôt de composés chloro ou fluoro-carbonés CClx ou CFx peu volatils provenant de la consommation de la réserve formant masque et/ou du craquage de gaz additionnels tels que $CCl_4$, $CHCl_3$, $CF_4$, $CHF_3$, $SiCl_4$ ou $NF_3$. Ce mécanisme inhibe la gravure par suppression de toute composante de gravure latérale sur les flancs du métal. Ainsi un procédé de gravure anisotrope de l'aluminium utilisable pour la fabrication de circuits intégrés, c'est-à-dire dont la consommation de masque de réserve reste compatible avec les topographies de ces circuits, peut être mis en oeuvre après un choix approprié des paramètres du plasma de gravure ionique, tels que pression de l'atmosphère gazeuse, puissance radio-fréquence, débit de gaz, mélange gazeux. Ce choix dépend d'ailleurs de la conception du réacteur de gravure ionique réactive. Un tel procédé a été décrit dans le document US-A-4 436 584 dans lequel une passivation du flanc du masque et de la couche est effectuée, au moyen d'un film polymère de protection, formé sur les flancs de la couche à graver, afin de conserver la dimension du motif.

Au-delà de la simple gravure anisotrope, le contrôle de la pente du profil des matériaux métalliques d'interconnexion présente l'intérêt technologique de permettre l'amélioration du pouvoir planarisant et de la qualité des dépôts des couches supérieures telles que les couches diélectriques intermétalliques ou d'encapsulation, quelle que soit la technique de dépôt diélectrique utilisée, avec pour conséquence une meilleure tenue et une meilleure fiabilité des puces électroniques à moyen ou long terme.

Toutefois, le contrôle du profil de gravure d'un matériau métallique, tel que l'aluminium, par érosion anisotrope de la réserve formant masque, selon la figure 1b, ou par dépôt des polymères sur les flancs de gravure en renforçant la composante dépôt-passivation de la figure 1c, présente une solution difficilement industrialisable. En effet, un tel résultat ne peut être obtenu qu'au prix d'une trop forte consommation de la réserve formant masque ou d'un environnement chimique de gravure trop polymérisant et donc générateur de particules, et, en conséquence, de défauts dans la définition du niveau métallique.

La présente invention a pour objet la mise en oeuvre d'un procédé de contrôle du profil de gravure d'une couche, notamment d'une couche métallique, d'un circuit intégré, ne présentant pas les inconvénients précités.

Un autre objet de la présente invention est la mise en oeuvre d'un procédé de contrôle du profil de gravure d'une couche, notamment d'une couche métallique, d'un circuit intégré permettant l'emploi de réactions et de produits chimiques peu ou pas polymérisants, ce qui permet de s'affranchir de l'apparition de défauts dans la définition du niveau de la couche, notamment la couche métallique.

Un autre objet de la présente invention est la mise en oeuvre d'un procédé de contrôle du profil de gravure d'une couche, notamment d'une couche métallique, d'un circuit intégré permettant un processus de gravure provoquant une faible consommation verticale, soit dans une direction orthogonale à la surface du substrat du circuit intégré, de la réserve formant masque, cette consommation étant, selon un autre objet du procédé objet de l'invention, rendue minimale, afin d'adapter le procédé objet de l'invention aux conditions d'exploitation industrielles.

Le procédé de gravure en pente du profil d'une couche d'un circuit intégré, objet de la présente invention est défini conformément à la revendication 1.

Le procédé objet de l'invention trouve application dans l'industrie de la fabrication des circuits intégrés à l'échelle industrielle.

Il sera mieux compris à la lecture de la description et à l'observation des dessins ci-après dans lesquels, outre les figures 1a, 1b, 1c relatives à l'art antérieur,

- la figure 2a représente de manière illustrative un mode de mise en oeuvre du procédé objet de la présente invention,
- la figure 2b représente un diagramme de l'efficience e, en pourcentage d'une érosion par gravure ionique réactive en fonction de l'angle d'incidence i, exprimé en degrés, du flux ionique issu du plasma sur une face exposée du substrat du circuit intégré,
- la figure 3, en ses différents points a) à d), représente différentes étapes d'un premier mode de réalisation du procédé objet de l'invention dans lequel la gravure de la réserve formant masque est effectuée pour une érosion minimale des flancs de la réserve formant masque,
- la figure 4, en ses différents points a) à d), représente différentes étapes d'un deuxième mode de réalisation du procédé objet de l'invention dans lequel les flancs de la réserve formant masque soumis à un profilage sont le siège d'une érosion plus intense, ce qui permet en fait d'assurer un transfert du profilage des flancs de la réserve formant masque au niveau des flancs de la couche à graver.

Le procédé de gravure en pente d'une couche d'un circuit intégré objet de la présente invention sera tout d'abord décrit en liaison avec la figure 2a.

D'une manière générale, le procédé objet de la présente invention consiste à réaliser la gravure en pente d'une couche de circuit intégré par la conjonction d'une passivation du flanc de gravure et d'une érosion non isotrope de la couche de réserve formant masque sur la couche dite couche à graver du circuit intégré précité.

Sur la figure 2a, la couche à graver porte la référence 1 et est revêtue d'une couche de réserve 2 formant masque suivant 2 dimensions contenues dans un plan orthogonal au plan de la feuille ou plan de coupe de la figure 2a.

Selon une caractéristique particulièrement avantageuse du procédé objet de l'invention, celui-ci consiste à effectuer conjointement une passivation, notée P, du flanc de gravure de la couche à graver 1 et une érosion non isotrope de la couche de réserve 2 formant masque, la réalisation conjointe des deux opérations précitées permettant de contrôler la pente, notée pe, du flanc de gravure de la couche à graver 1.

D'une manière générale, on comprendra que le contrôle de la pente pe précitée du flanc de gravure de la couche 1 est obtenu pour une faible consommation dans la direction verticale de la couche de réserve 2 formant masque et par l'emploi, pour réaliser l'érosion non isotrope de la couche de réserve précitée, d'un processus de gravure ionique réactive par exemple, en milieu de gravure à activité polymérisante très faible, soit en l'absence de dépôt de composés chloro- ou fluorocarbonés.

Selon un premier mode opératoire tel que représenté en figure 2a, le procédé objet de la présente invention consiste, en vue d'effectuer le contrôle de la pente du flanc de gravure de la couche à graver 1, à effectuer un profilage de la couche de réserve 2 au pied du flanc de celle-ci. De manière non limitative, le pied du flanc est défini comme la zone latérale de la couche de réserve formant masque située au voisinage de la couche à graver 1, cette zone latérale, ainsi que représentée en coupe sur la figure 2a, perpendiculaire à la surface de la couche à graver 1 au début de la mise en oeuvre du procédé objet de la présente invention, devenant peu à peu, au cours du procédé, inclinée selon une pente pe du fait de l'érosion non isotrope de la couche de réserve 2 formant masque précédemment mentionnée.

En outre, conformément au mode opératoire précité, celui-ci consiste alors à effectuer simultanément le transfert du profilage de la couche de réserve 2 au niveau de la couche à graver 1 par gravure anisotrope, symbolisée par le champ électrique E accélérateur d'un flux ionique de gravure, de la couche de réserve 2. La couche de réserve profilée 2 au pied du flanc de celle-ci est ainsi soumise à l'érosion non isotrope du fait de la conjonction de la gravure anisotrope provoquée par gravure ionique et du dépôt conjoint d'un composé peu volatile sur le pied du flanc de la couche de réserve précitée. La conjonction des deux phénomènes provoque ainsi, d'une part, le profilage de la couche de réserve 2 au pied du flanc de cette dernière, et le transfert au niveau de la couche à graver 1 de l'érosion non isotrope, c'est-à-dire de la gravure anisotrope par l'intermédiaire de la gravure ionique réactive E et de la passivation du flanc de gravure de la couche à graver 1. La pente pe formée en premier lieu au niveau de la couche de réserve 2 est ainsi transférée au niveau du flanc de gravure de la couche à graver 1.

D'une manière générale, on considérera que, afin d'assurer le caractère anisotrope de la gravure ionique réactive, celle-ci est effectuée à basse pression, c'est-à-dire à une pression de gaz ambiant inférieure à 200 mTorr.

En outre, le caractère d'anisotropie de la gravure ionique réactive est assuré par une dilution de l'atmosphère de gravure ionique réactive, cette atmosphère pouvant être constituée par un composé chloré dilué dans un gaz neutre tel que l'azote ou l'argon. On notera que l'utilisation d'une telle atmosphère de gravure ionique réactive permet d'apporter une composante de gravure purement physique, c'est-à-dire provoquée par la seule accélération des ions par le champ électrique E représenté en figure 2a par exemple.

En ce qui concerne la composante de dépôt formant la passivation P du flanc de gravure de la couche à graver 1, et préalablement le profilage de la couche de réserve 2 au pied du flanc de cette dernière, une telle composante de dépôt peut alors être avantageusement obtenue par addition à l'atmosphère de gravure précédemment décrite d'un gaz peu volatil et ne produisant pas directement de composé carboné. Un tel gaz peut par exemple être constitué par le chlorosilane $SiCl_4$.

Selon ce même mode opératoire représenté en figure 2a, le contrôle de la pente pe du flanc de gravure de la couche à graver 1 est réalisé par la réalisation simultanée d'un facettage de la couche de réserve 2 au sommet du flanc de celle-ci grâce au processus de gravure anisotrope précédemment mentionné.

On notera qu'une telle opération de facettage permet au cours de l'étape d'érosion non isotrope d'engendrer concurremment une consommation locale plus importante de la couche de réserve 2 au niveau des arêtes des motifs du facettage et une formation de composés carbonés se redéposant au pied du motif et de la couche à graver 2, ce qui permet d'effectuer le contrôle de la pente pe ou profil de gravure de la couche à graver 1.

D'une manière générale, on comprendra que le facettage de la couche de réserve 2 au sommet du flanc de cette dernière est effectué sous incidence normale au substrat du plasma ionique réactif symbolisé par la flèche E. Le plasma précité présente, ainsi que représenté en figure 2b, un maximum de taux de pulvérisation pour une incidence comprise entre 40° et 60° par rapport à la normale, à la surface locale du substrat ou de la réserve formant masque 2. Dans le mode opératoire précité, les facettes engendrées par l'opération de facettage de la couche de réserve 2 formant masque sont obtenues par érosion préférentielle, au voisinage du rayon de courbure des arêtes de la couche de réserve 2. Les facettes précitées telles que représentées en figure 2a et notées f présentent ainsi une inclinaison par rapport à la direction d'incidence du plasma comprise entre 40 et 60° et correspondent ainsi au maximum du taux de pulvérisation e tel que représenté en figure 2b, en fonction de l'angle d'incidence i.

On notera que le phénomène de facettage provient de la dépendance du taux de pulvérisation e, dû à la composante physique de la gravure ionique réactive, vis-à-vis de l'angle d'incidence des ions. Le maximum de taux de pulvérisation correspond à une amplification de la consommation des facettes de la couche de réserve formant masque d'un facteur 2 à 10.

Afin de mettre en oeuvre le processus de facettage tel que précédemment décrit, la composante physique de la gravure par gravure ionique réactive de la couche de réserve formant masque doit être importante. Une telle situation correspond à une composante chimique ou réactive réduite, c'est-à-dire à la réalisation du processus de gravure ionique réactive en régime de faible consommation de couche de réserve formant masque. Une telle gravure peut être réalisée à basse pression, c'est-à-dire à une pression d'atmosphère de gravure ionique réactive, c'est-à-dire inférieure à 200 mTorr constituée par un gaz réactif tel que le chlore, $Cl_2$, dilué par l'azote ou l'argon, ainsi que précédemment décrit en liaison avec le processus de transfert de la pente pe du pied du flanc de la couche de réserve 2.

On comprendra aisément que le processus de contrôle de la pente du profil gravé peut être effectué conformément du processus précédemment décrit, c'est-à-dire par l'intermédiaire du, processus de transfert du profilage de la couche de réserve au niveau de la couche à graver 1, et du processus de facettage de la couche de réserve au sommet du flanc de celle-ci, précédemment décrits dans la description.

On comprendra en particulier que le processus de gravure par gravure ionique réactive doit ainsi être effectué, dans l'un et/ou dans l'autre cas, à l'aide d'un mélange gazeux du type $N_2$-$Cl_2$, Ar-$Cl_2$, $N_2$-$Cl_2$-$SiCl_4$, Ar-$Cl_2$-$SiCl_4$, $N_2$-$Cl_2$-$SiCl_4$-$BCl_3$ ou Ar-$Cl_2$-$SiCl_4$-$BCl_3$, ce qui permet de contrôler la valeur de la pente du profil gravé par l'un et/ou par l'autre des processus précédemment mentionnés.

On notera que la puissance radio-électrique ou puissance radio-fréquence appliquée pour engendrer le plasma de gravure par gravure ionique réactive dépend bien entendu du réacteur de gravure utilisé, mais doit être suffisante pour assurer l'anisotropie intrinsèque nécessaire aux mécanismes précédemment mentionnés. On notera que d'une manière pratique, le niveau de puissance requis reste tout à fait standard.

Pour la réalisation dans une couche à graver 1 constituée par une couche d'aluminium, la pente pe étant de 50° à 90° par rapport à la base du substrat du circuit intégré, on indiquera que la vitesse d'attaque de gravure de l'aluminium doit être comprise entre 7000 à 13 000 A/mn, alors que la vitesse d'attaque de la couche de réserve 2 formant masque doit être comprise entre 2 000 à 5 000 A/mn.

On notera que le contrôle de la pente pe est effectué directement par celui de la composition de l'atmosphère de gravure, c'est-à-dire par les proportions d'azote $N_2$ ou d'argon Ar, ou de $Cl_2$ et de chlorosilane $SiCl_4$.

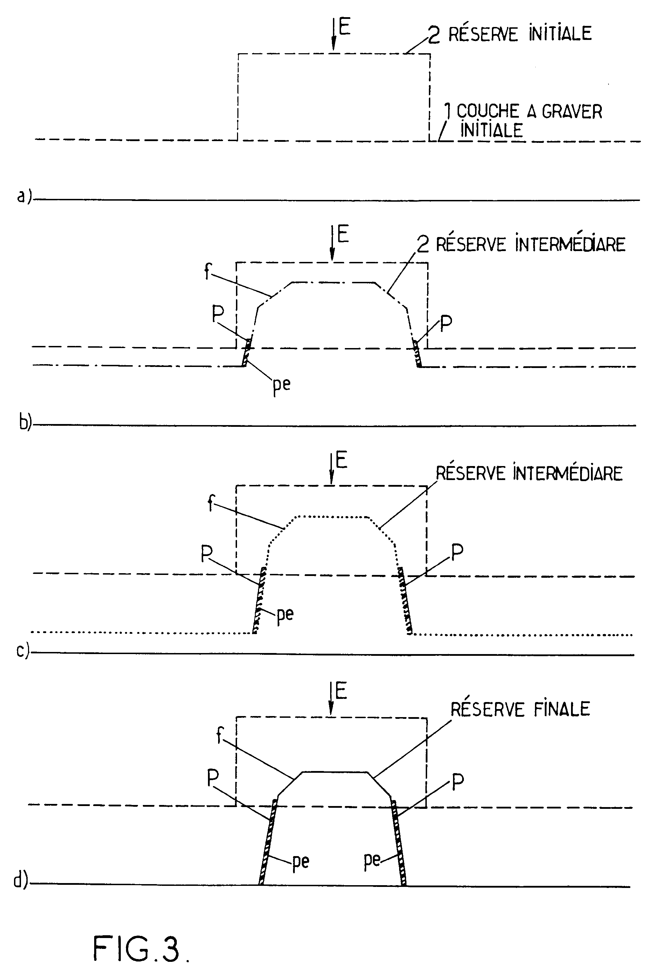

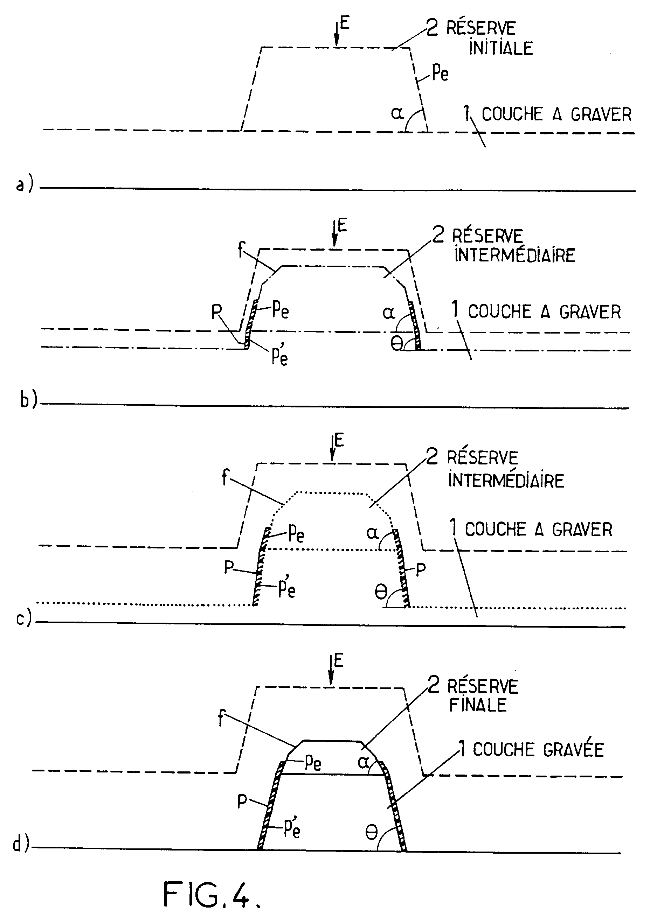

Une description plus détaillée de l'un et/ou l'autre processus de contrôle de la pente pe du flanc de gravure de la couche à graver 1 sera donnée en liaison avec la figure 3, respectivement avec la figure 4.

D'une manière générale, on considérera que le procédé objet de la présente invention peut être caractérisé par l'élément fondamental ci-après.

Pour un angle $\alpha$ instantané du pied de la couche de réserve 2 formant masque, l'angle $\theta$ instantané du flanc de gravure de la couche à graver 1 est tel que le rapport des tangentes des deux angles est proportionnel au rapport de la vitesse de gravure apparente de la couche à graver, notée vcg, c'est-à-dire de la gravure non isotrope résultant de la gravure anisotrope dans la direction verticale due à la gravure ionique réactive et du dépôt concurrentiel de passivation, et de la vitesse de gravure de la réserve formant masque, notée vcr, diminuée d'un terme produit de la vitesse de dépôt isotrope de la couche de passivation P, cette vitesse étant notée D, par la tangente de l'angle $\alpha$ instantané du pied de la couche de réserve formant masque.

Les angles précédemment cités vérifient la relation :

$$tg\ \theta = \frac{vcg \cdot tg\alpha}{vcr\text{-}D.tg\alpha}$$

Une description plus détaillée de la mise en oeuvre du processus de contrôle du profil de gravure d'une couche d'un circuit intégré objet de la présente invention sera donnée en liaison avec la figure 3 dans le cas où la couche de réserve formant masque ne comporte aucun processus de prégravure initiale, le flanc de la couche de réserve formant masque étant ainsi sensiblement orthogonal à la couche à graver initiale 1, respectivement la figure 4, dans le cas où, au contraire, la couche de réserve formant masque 2 est soumise à un processus de prégravure, le flanc de la couche de réserve 2 formant masque présentant une inclinaison ou pente pe, ce flanc formant un angle $\alpha$ par rapport à la surface de la couche à graver 1.

Conformément à la figure 3, ainsi que représenté au point a) de celle-ci, la couche de réserve 2 formant masque initial présente un flanc orthogonal à la surface libre de la couche à graver 1, laquelle est présumée horizontale. Le processus de gravure proprement dit par gravure ionique réactive symbolisé par la flèche E permet de passer au point b) par constitution d'une érosion non isotrope de la couche de réserve 2 formant masque, un profilage de cette couche de réserve 2 au pied du flanc de celle-ci étant effectué par la création d'un flanc de pente pe, ce flanc de gravure et le profilage de couche de réserve 2 étant ainsi transférés au niveau de la couche à graver 1, du fait de la gravure anisotrope E de la couche de réserve 2, ainsi que représenté au point b) précité. On notera bien sûr que, pendant ce processus, la passivation P du flanc de gravure de la couche à graver 1 est effectuée du fait de la présence des produits d'érosion de la couche 2 de réserve formant masque.

Au point c) de la figure 3, le processus de transfert est maintenu, ce qui permet de conserver la pente pe du flanc de gravure de la couche de réserve 2 formant masque et, bien entendu, de la couche à graver 1, du fait du transfert du profilage ainsi obtenu.

Enfin, au point d) de la figure 3, la couche à graver 1 à été totalement réduite, sauf en ce qui concerne la partie située sous la couche de réserve 2 formant masque final, la pente pe de la couche de réserve 2 précitée et de la partie restante de la couche à graver 1 étant bien entendu maintenue. On comprendra bien sûr que le résidu de la couche de réserve 2 formant masque finale, ainsi que la passivation P présente sur les flancs de gravure de la couche à graver 1 peuvent ensuite être supprimés par tout traitement chimique de type classique adapté.

On notera enfin qu'au cours du processus tel que représenté en figure 3, et en particulier aux points b), c), et d), de celle-ci, le phénomène de facettage caractéristique de la mise en oeuvre du procédé objet de la présente invention a été mis en évidence par la matérialisation des facettes f au sommet de la couche de réserve formant masque intermédiaire ou finale.

Dans le cas de la figure 4 au contraire, la couche 2 de réserve formant masque initiale, préalablement au processus de gravure proprement dit, a été soumise à une étape de prégravure, laquelle a pour effet d'engendrer des flancs de gravure de pente pe inclinés par rapport à la surface libre de la couche 1 à graver, présumée horizontale, les flancs de gravure de la couche de réserve 2 formant masque initiale étant ainsi inclinés d'un angle $\alpha$ par rapport à la surface libre précitée. On notera que le processus de prégravure peut consister en une gravure douce, laquelle a pour propriété d'attaquer de manière sélective la couche 2 de réserve formant masque initiale, à l'exclusion d'une attaque de la couche 1 à graver. Au contraire, la couche 2 de réserve formant masque initiale peut être déposée et traitée de façon à présenter des flancs de gravure présentant la pente pe telle que représentée au point a) de la figure 4.

La mise en oeuvre du procédé objet de la présente invention tel que représenté au point a) de la figure 4 permet alors par gravure ionique réactive, symbolisée par la flèche E, d'effectuer, d'une part, le profilage des flancs de gravure de la couche 2 de réserve formant masque, la passivation conjointe P du flanc de gravure de la couche à graver 1 et, finalement, le transfert du profilage de la couche de réserve 2 précitée au niveau de la couche à graver 1, conformément à la relation précédemment mentionnée dans la description. Ainsi que représenté aux points b) et c) notamment de la figure 4, la couche à graver 1 présente alors un flanc de gravure présentant une inclinaison d'un angle $\theta$ par rapport à la surface libre de la couche à graver intermédiaire 1, l'angle $\theta$ vérifiant la relation précitée et correspondant à une inclinaison de pente p'e obtenue par transfert de la pente pe de la couche 2 de réserve formant masque. On notera bien sûr que dans la relation précédemment mentionnée, la vitesse de gravure de la couche à graver vcg désigne la vitesse de gravure apparente ou nette dans la direction verticale de la gravure et du dépôt concurrentiel issus de l'érosion de la couche 2 formant masque et constituant la passivation P du flanc de gravure de la couche à graver 1.

On notera également que dans la relation précitée, D désigne la vitesse de dépôt isotrope des produits d'érosion de la couche 2 de réserve formant masque, cette vitesse de dépôt isotrope ne se manifestant que par sa composante horizontale.

Au point d) de la figure 4, on a représenté la couche gravée finale présentant l'angle θ précédemment mentionné, alors que la couche 2 de réserve formant masque présente au contraire au niveau de son flanc de gravure un angle α correspondant.

On notera dans tous les cas, tel que représenté aux points b), c), d), de la figure 4, que le phénomène de facettage est également obtenu, ce phénomène de facettage étant représenté par la notation f au sommet de la couche 2 de réserve formant masque.

Des exemples de mise en oeuvre du procédé objet de la présente invention seront maintenant donnés dans le cas de la gravure de l'aluminium et, respectivement, du tungstène.

Gravure de l'aluminium.

- Obtention d'un profil d'angle θ = 75° pour :

    . débit de gaz : 50 sccm $SiCl_4$ - 40 sccm $Cl_2$ - 60 sccm $N_2$
    . pression : 60 mTorr
    . puissance RF : 300 W (2,4 Watt/cm2).

- Obtention d'un profil d'angle θ = 85 ° pour :

    . débit de gaz : 40 sccm $SiCl_4$ - 65 sccm $Cl_2$ - 70 sccm $N_2$
    . pression : 110 mTorr
    . puissance RF : 350 Watt (2,9 W/cm2).

On rappellera que dans les valeurs précédemment mentionnées, sccm désigne l'abréviation en langage anglo-saxon pour "standard cubic centimeter per minute", soit cm3/mn. D'autre part, on rappelle que, pour ce qui concerne l'aluminium, la vitesse d'attaque est comprise entre 7 000 à 13 000 A/mn, alors que la vitesse d'attaque de la couche de réserve formant masque est comprise entre 2 000 et 5 000 A/mn.

Gravure du tungstène.

On notera qu'en ce qui concerne la gravure d'une couche à graver en tungstène par exemple, conformément au procédé objet de la présente invention, une telle gravure peut être effectuée en mode gravure ionique réactive (RIE) à pression inférieure à 200 mTorr à l'aide d'un mélange gazeux du type $N_2$ - $SF_6$, $N_2$-$NF_3$,

Ar-$SF_6$, Ar-$NF_3$, $N_2$-$SF_6$-$Cl_2$, Ar-$SF_6$-$Cl_2$, $N_2$-$NF_3$-$Cl_2$, Ar-$NF_3$-$Cl_2$. L'utilisation des mélanges de gaz précités, dans les conditions de pression précédemment mentionnées, permet de contrôler la pente du profil gravé conformément à l'un et/ou l'autre des processus de contrôle de pente décrits précédemment dans la description. On notera bien sûr que la puissance radio-fréquence RF appliquée dépend du réacteur de gravure, mais doit être suffisante pour assurer l'anisotropie intrinsèque nécessaire au mécanisme proposé.

En ce qui concerne plus particulièrement le tungstène, les conditions opératoires étaient les suivantes :

- vitesse d'attaque du tungstène : 2 000 à 10 000 A/mn,
- vitesse d'attaque de la couche de réserve formant masque : 1 000 à 10 000 A/mn,
- angle au pied de la couche de photorésist par prégravure : 60 à 90°.

Un exemple de mise en oeuvre a permis d'obtenir les résultats suivants pour le tungstène :

- obtention d'un profil de gravure à 75° pour :

    . débit de gaz : 50 sccm $SF_6$ - 20 sccm $N_2$,
    . pression : 150 mTorr,
    . puissance : RF 250 Watt (2 W/cm2).

On a ainsi décrit un procédé de gravure en pente d'une couche d'un circuit intégré particulièrement performant, puisque le procédé objet de la présente invention permet d'effectuer la gravure en pente de couches de matériau de circuit intégré, telles que des couches métalliques d'aluminium ou de tungstène, ou même de couches non métalliques telles que le polysilicium.

D'une manière générale, on considérera que, les couches susceptibles d'être gravées conformément à la mise en oeuvre du procédé objet de la présente invention sont, d'une part, des couches de type aluminium, ce matériau pouvant en outre être dopé par des matériaux tels que le silicium, le titane, le cuivre, les alliages de silicium et de cuivre et de silicium et de titane, ces couches pouvant en outre comporter une sous-couche barrière ou d'accrochage telle que des couches de titane, de nitrure de titane, TiN, de l'alliage, TiW, et, d'autre part, les matériaux d'interconnexion, du type tungstène, lesquels peuvent également comporter une sous-couche barrière ou d'accrochage.

**Revendications**

1. Procédé de gravure en pente d'une couche d'un circuit intégré, dite couche à graver (1), cette couche étant revêtue d'une couche de réserve (2) formant masque et présentant un flanc de gravure pendant l'opération de gravure, consistant à effectuer conjointement, pendant le processus de gravure :

- une passivation (P) du flanc de gravure de ladite couche à graver (1),
- une érosion non isotrope de ladite couche de réserve formant masque (2), en vue de contrôler la pente du flanc de gravure de ladite couche à graver (1), ladite érosion non isotrope consistant à réaliser un profilage à partir d'un facettage par gravure anisotrope de ladite couche de réserve formant masque au pied du flanc de cette couche de réserve, ladite érosion non isotrope étant effectuée par un processus de gravure ionique réactive, par gravure anisotrope et dépôt conjoint d'un composé peu volatil sur le pied du flanc de la couche de réserve réalisant cette passivation, en milieu de gravure à activité polymérisante très faible, l'atmosphère de gravure consistant en du chlore et/ou un composé chloré et/ou fluoré dilué dans un gaz neutre en l'absence de chaîne carbonée, soit en l'absence de dépôt de composés chloro- au fluorocarbonés, et à transférer simultanément ce profilage de la couche de réserve formant masque dans la région de la couche à graver par gravure anisotrope de la couche de réserve formant masque, soumise à l'érosion non isotrope, le rapport de la tangente de l'angle instantané a du pied de la couche de réserve formant masque et de l'angle θ du flanc de gravure de la couche à graver (1) étant proportionnel au rapport de la vitesse apparente de gravure vcg de la couche à graver (1) et de la vitesse de gravure vcr de la couche de réserve formant masque, diminuée d'un terme égal au produit de la vitesse de dépôt isotrope D de la couche de passivation multipliée par la tangente de l'angle instantané a du pied de la couche de réserve formant masque, ce rapport vérifiant la relation :

$$tg\theta = \frac{vcg \cdot tg\alpha}{vcr\text{-}D.tg\alpha} .$$

2. Procédé selon la revendication 1, caractérisé en ce que le facettage de ladite couche de réserve (2) au sommet du flanc de celle-ci est effectué sous incidence normale au substrat du plasma ionique réactif (E), ledit plasma présentant un maximum de taux de pulvérisation pour une incidence comprise entre 40° et 60° par rapport à la normale à la surface locale du substrat ou de la réserve formant masque, les facettes engendrées par l'opération de facettage de la couche de réserve (2) formant masque étant obtenues par érosion préférentielle au voisinage du rayon de courbure des arêtes de la couche de réserve (2) et présentant ainsi une inclinaison, par rapport à la direction d'incidence du plasma, comprise entre 40° et 60°, correspondant au maximum du taux de pulvérisation.

## Claims

1. Process for sloping etching of a layer of an integrated circuit, called layer to be etched (1), this layer being coated with a masking photoresist layer (2) provided with an etching flank during etching operation, said process consisting in performing jointly during this etching operation :

- a passivation (P) of the etching flank of said layer to be etched (1) ;
- a non-isotropic erosion of said masking photoresist layer (2), so as to control the slope of the etching flank of said layer to be etched (1), said non-isotropic erosion consisting in performing a profiling from faceting through anisotropic etching of said masking photoresist layer at the flank foot of the latter, said non isotropic erosion being performed by reactive ioning etching, through an anisotropic etching and conjoint deposition of a low volatility compound of the foot of the flank of the masking photoresist layer forming said passivation, performed within an etching medium of very low polymerising activity, the etching atmosphere consisting in chlorine and/or a chlorinited and/or a fluorineted compound, diluted in a neutral gas, in the absence of carbon chain, that is in the absence of deposition of chloro- or fluorocarbon compounds, said non-isotropic erosion simultaneously consisting in transferring said profiling of the photoresist masking layer within the region of the layer to be etched by anisotropic etching of said photoresist masking layer, submitted to the non-isotropic erosion, the ratio of the tangent of the momentary angle α of the foot of the masking photoresist layer and the tangent of the momentary angle θ of the etching flank of the layer to be etched (1) being proportional to the ratio of the apparent rate of etching vcg of the layer to be etched (1) and of the rate of etching vcr of the masking photoresist decreased by a term which is the product of the rate D of isotropic deposition of the passivation layer multiplied by the tangent of the momentary angle α of the foot of the masking photoresist layer,

$$tg\theta = \frac{vcg.tg\alpha}{vcr\text{-}D.tg\alpha} .$$

2. The process as claimed in claim 1, characterised in that the faceting of said photoresist layer (2) at the top of the flank of the latter is performed at normal incidence to the substrate of the reactive ionic plasma (E), said plasma exhibiting a maximum rate of sputtering in the case of an incidence of between 40° and 60° to the normal to the local surface of the substrate or of the masking photoresist, the facets produced by the operation of faceting of the masking photoresist layer (2) being obtained by preferential erosion in the vicinity of the radius of curvature of the ridges of the photoresist layer (2) and thus exhibiting an inclination of between 40° and 60° in relation to the direction of incidence of the plasma, corresponding to the maximum of the degree of sputtering.

**Patentansprüche**

1. Verfahren zum Schrägätzen einer Schicht einer integrierten Schaltung, genannt zu ätzende Schicht (1), wobei diese Schicht mit einer Abdeckschicht (2) beschichtet ist, die eine Maske bildet und eine Ätzflanke während des Ätzprozesses aufweist, der darin besteht, während des Ätzvorgangs die Schritte gemeinsam durchzuführen:

   - eine Passivierung (P) der Ätzflanke der zu ätzenden Schicht (1),
   - eine nicht isotrope Erosion der maskenbildenden Abdeckschicht (2) im Hinblick auf die Kontrolle der Schräge der Ätzflanke der zu ätzenden Schicht (1), wobei die nicht isotrope Erosion darin besteht, eine Profilierung ausgehend von einer Facettierung durch anisotropes Ätzen der maskenbildenden Abdeckschicht am Flankenfuß dieser Abdeckschicht durchzuführen, wobei die nicht isotrope Erosion durch ein reaktives Ionenätzverfahren erfolgt, durch anisotropes Ätzen gemeinsam mit einer Ablagerung am Flankenfuß der Abdeckschicht einer wenig flüchtigen Komponente, die diese Passivierung bewirkt, mit sehr geringer Polymerisierungsaktivität in der Ätzatmosphäre, wobei die Ätzatmosphäre aus Chlor besteht und/oder einer Chlorverbindung und/oder einer Fluorverbindung, in einem Neutralgas verdünnt, unter Abwesenheit von Kohlenstoffketten oder unter Abwesenheit von Ablagerungen aus Chlor- oder Fluorkohlenstoffverbindungen, und gleichzeitig diese Profilierung der maskenbildenden Abdeckschicht in den Bereich der zu ätzenden Schicht durch anisotropes Ätzen der maskenbildenden Abdeckschicht zu übertragen, die der nicht isotropen Erosion ausgesetzt ist, wobei das Tangensverhältnis des momentanen Winkels $\alpha$ des Fußes der maskenbildenden Abdeckschicht und des Winkels $\theta$ der Ätzflanke der zu ätzenden Schicht (1) proportional ist zum Verhältnis der Schein-Ätzgeschwindigkeit vcg der zu ätzenden Schicht (1) und der Ätzgeschwindigkeit vcr der maskenbildenden Abdeckschicht, welche verringert ist um einen Term, der gleich ist dem Produkt der isotropen Ablagerungsgeschwindigkeit D der Passivierungsschicht, multipliziert mit dem Tangens des momentanen Winkels $\alpha$ des Fußes der maskenbildenden Abdeckschicht, wobei dieses Verhältnis die Beziehung erfüllt:

$$\text{tg}\,\theta = \frac{vcg \cdot \text{tg}\,\alpha}{vcr\text{-}D \cdot \text{tg}\,\alpha}$$

2. Verfahren nach Anspruch 1, **dadurch gekennzeichnet,** daß die Facettierung der Abdeckschicht (2) an der Spitze ihrer Flanke bei normalem Einfall des reaktiven Ionenplasmas (E) auf das Substrat erfolgt, wobei das Plasma ein Maximum der Zerstäubungsrate bei einem Einfall aufweist, der zwischen 40° und 60° bezüglich der Normalen zur lokalen Oberfläche des Substrats oder der maskenbildenden Abdeckung enthalten ist, wobei die durch den Facettierungsprozeß der maskenbildenden Abdeckschicht (2) erzeugten Facetten durch bevorzugte Erosion in der Nähe des Krümmungsradius der Kanten der Abdeckschicht (2) erhalten werden und somit bezüglich der Einfallsrichtung des Plasmas eine zwischen 40° und 60° enthaltene Neigung entsprechend dem Maximum der Zerstäubungsrate aufweisen.

EP 0 528 713 B1

FIG.1a. (ART ANTERIEUR)

EROSION ISOTROPE DE LA RÉSERVE

FIG.1b. (ART ANTERIEUR)

ÉROSION ANISOTROPE DE LA RÉSERVE

9

RÉSERVE
INTERMÉDIAIRE

RÉSERVE
INITIALE

RÉSERVE
FINALE

GRAVURE
INTERMÉDIAIRE

PASSIVATION INTERMÉDIAIRE

GRAVURE FINALE

PASSIVATION FINALE

MÉTAL

## FIG.1c. (ART ANTERIEUR)
EROSION ANISOTROPE DE LA RESERVE ET
PASSIVATION DU FLANC DE GRAVURE

## FIG.2a.

PASSIVATION P
INTERMÉDIAIRE

2 RÉSERVE
INITIALE

RÉSERVES
INTERMÉDIAIRES

PASSIVATION P
FINALE

RÉSERVE
FINALE

1 COUCHE A GRAVER INITIALE

COUCHESAGRAVER INTERMÉDIAIRES

pe

COUCHE A GRAVER FINALE

## FIG.2b.

↓E

2 RÉSERVE INITIALE

1 COUCHE A GRAVER
INITIALE

a)

↓E

2 RÉSERVE INTERMÉDIARE

f

P

P

pe

b)

↓E

RÉSERVE INTERMÉDIARE

f

P

P

pe

c)

↓E

RÉSERVE FINALE

f

P

P

pe    pe

d)

FIG.3.

a)

E

2 RÉSERVE INITIALE

Pe

α

1 COUCHE A GRAVER

b)

E

f

2 RÉSERVE INTERMÉDIAIRE

P    Pe

P'e

α

θ

1 COUCHE A GRAVER

c)

E

f

2 RÉSERVE INTERMÉDIAIRE

Pe

P

P'e

α

P

θ

1 COUCHE A GRAVER

d)

E

f

2 RÉSERVE FINALE

Pe

P

P'e

α

θ

1 COUCHE GRAVÉE

FIG.4.